# EUROPEAN PATENT APPLICATION

(11) **EP 4 181 207 A1**
(43) Date of publication of application: **17.05.2023**
(21) Application number: 21838874.2
(22) Date of filing: 09.07.2021
(51) Int. Cl.: H01L 29/06, H01L 29/872, H02M 3/155, H02M 7/12

(54) **POWER CONVERSION CIRCUIT AND POWER CONVERSION SYSTEM**

(30) Priority: 10.07.2020 JP 2020119495; 10.07.2020 JP 2020119496
(71) Applicant: Flosfia Inc., Kyoto 615-8245 (JP)
(72) Inventor: KITAKADO, Hidehito, Kyoto-shi, Kyoto 615-8245 (JP); MATSUBARA, Yusuke, Kyoto-shi, Kyoto 615-8245 (JP)
(74) Representative: Gulde & Partner
(86) International application number: PCT/JP2021/025889
(87) International publication number: WO 2022/009970

(57) **Abstract**

Provided is a power conversion circuit and a power conversion system configured with reduced radiated noise. The power conversion circuit including at least: a switching element that opens and closes an inputted voltage via a reactor; and a commutating diode that passes a current in a direction of an electromotive force by a voltage including at least the electromotive force generated from the reactor when the switching element is turned off, the commutating diode including a gallium oxide-based Schottky barrier diode.

## Description

### Technical Field

The present disclosure relates to a power conversion circuit and a power conversion system.

### Background Art

As next-generation switching elements capable of obtaining high-voltage, low loss and high heat resistance, semiconductor devices configured using gallium oxide (Ga₂O₃) with a large band gap have received much attention. Such semiconductor devices are expected to be applied to power semiconductor devices for inverters and converters or the like. Furthermore, such semiconductor devices with large band gaps are expected to be applied as light emitters and light receivers for LEDs and sensors or the like. According to Non Patent Literature 1, the above-mentioned gallium oxide is allowed to be subjected to band gap control by mixing crystals with indium, aluminum, or a combination thereof, thereby configuring a quite attractive family of materials as an InAlGaO-based semiconductor. Here, InAlGaO-based semiconductors indicates InₓAl_{Y}Ga_{Z}O₃ (0 ≤ X ≤ 2, 0 ≤ Y ≤ 2, 0 ≤ Z ≤ 2, X + Y + Z = 1.5 to 2.5) and may be regarded as a family of materials including gallium oxide.

PTL 1 describes that a Schottky diode containing a β-Ga₂O₃ semiconductor is used as a freewheel diode of a switching circuit including a Schottky diode and a transistor. However, problems in actual integration into a switching circuit have not been sufficiently examined. Furthermore, problems such as low thermal conductivity of a gallium oxide substrate have interfered with the industrial use.

Moreover, PTL 2 describes that a wide bandgap semiconductor element (any one of silicon carbide, gallium nitride, gallium oxide, and diamond or a combination thereof) is used for some or all of diodes or switching elements in the switching unit of an ac-to-dc converter. However, problems to be solved for each semiconductor element have not been examined, and radiated noise has not been sufficiently treated. The use of gallium oxide, in particular, has caused heat generation over a circuit.

Hence, a power conversion circuit with suppressed radiated noise and heat generation has been demanded.

### Related Art

### Patent Literature

PTL 1: Japanese Patent Application Publication No. 2010-233406
PTL 2: Japanese Patent Application Publication No. 2016-27779

### Non-Patent Literature

NPL 1: Kentaro Kaneko, "Growth and Physical Properties of Corundum Structured Gallium Oxide Mixed Crystal Thin Films," Dr. Thesis of Kyoto University, March 2013

### Summary of Invention

### Technical Problem

An object of the present disclosure is to provide a power conversion circuit with suppressed radiated noise.

As a result of a thorough examination to attain the object, the inventors found that a power conversion circuit capable of solving the conventional problems all at once includes at least a switching element that opens and closes an inputted voltage via a reactor and a commutating diode that passes a current in the direction of an electromotive force by a voltage including at least the electromotive force generated from the reactor when the switching element is turned off, the commutating diode including a Schottky barrier diode of gallium oxide, the power conversion circuit being capable of reducing radiated noise as compared with a power conversion circuit with a Si diode or a SiC diode serving as a commutating diode.

Specifically, the disclosure relates to disclosures as follows.
[1] A power conversion circuit comprising at least: a switching element that opens and closes an inputted voltage via a reactor; and a commutating diode that passes a current in a direction of an electromotive force by a voltage including at least the electromotive force generated from the reactor when the switching element is turned off, the commutating diode including a gallium oxide-based Schottky barrier diode.
[2] The power conversion circuit according to [1], wherein the reactor is disposed on an input side than the commutating diode.
[3] The power conversion circuit according to [1] or [2], further comprising an output capacitor, the power conversion circuit being configured to supply the current to the output capacitor.
[4] The power conversion circuit according to any one of [1] to [3], wherein the switching element includes a freewheel diode.
[5] The power conversion circuit according to any one of [1] to [4], wherein the switching element includes a gallium oxide-based MOSFET, a gallium oxide-based IGBT, a gallium nitride-based HEMT, a SiC-based MOSFET, or a SiC-based IGBT.
[6] The power conversion circuit according to any one of [1] to [5], wherein different semiconductors are used for the switching element and the commutating diode.
[7] The power conversion circuit according to any one of [1] to [6], wherein the semiconductor used for the gallium oxide-based Schottky barrier diode has a larger band gap than a band gap of the semiconductor used for the switching element.
[8] The power conversion circuit according to any one of [1] to [7], wherein the gallium oxide-based Schottky barrier diode includes at least an n- type semiconductor layer having a carrier concentration of 2.0 × 10¹⁷/cm³ or less.
[9] The power conversion circuit according to [8], wherein the n- type semiconductor layer has a thickness of 1 µm to 10 µm.
[10] The power conversion circuit according to any one of [1] to [9], wherein the power conversion circuit is a step-up conversion circuit.
[11] A power conversion system comprising at least: a switching element that opens and closes an input voltage via a reactor, the input voltage being supplied from a power supply; a control circuit that controls on and off of the switching element; a commutating diode that passes a current in a direction of an electromotive force by a voltage including at least the electromotive force generated from the reactor when the switching element is turned off; and an output capacitor, wherein a gallium oxide-based Schottky barrier diode is used as the commutating diode.
[12] The power conversion system according to [11], wherein the reactor is disposed on an input side than the commutating diode.
[13] The power conversion system according to [11] or [12], wherein the switching element includes a freewheel diode.
[14] The power conversion system according to any one of [11] to [13], wherein the switching element includes a gallium oxide-based MOSFET, a gallium oxide-based IGBT, a gallium nitride-based HEMT, a SiC-based MOSFET, or a SiC-based IGBT.
[15] The power conversion system according to any one of [11] to [14], wherein the gallium oxide-based Schottky barrier diode includes at least an n- type semiconductor layer having a carrier concentration of 2.0 × 10¹⁷/cm³ or less.

### Advantageous Effect of Invention

A power conversion circuit according to the present disclosure is configured with reduced radiated noise.

### Brief Description of Drawings

FIG. 1 is a circuit diagram schematically illustrating a power conversion system according to a first embodiment of the present disclosure.
FIG. 2 is a circuit diagram schematically illustrating a power conversion system according to a second embodiment of the present disclosure.
FIG. 3 is a circuit diagram schematically illustrating a power conversion system according to a third embodiment of the present disclosure.
FIG. 4 schematically illustrates a preferred example of a Schottky barrier diode according to the embodiments of the present disclosure.
FIG. 5 shows PFC operation waveforms in an example and a comparative example.
FIG. 6 shows a diode turn-off waveform in the example.
FIG. 7 shows a diode turn-off waveform in the comparative example.
FIG. 8 shows a diode turn-off waveform in a comparative example.
Fig. 9 is a block diagram illustrating an example of a control system applying the semiconductor device according to an embodiment of the disclosure.
Fig. 10 is a circuit diagram illustrating an example of the control system applying the semiconductor device according to an embodiment of the disclosure.
Fig. 11 is a block configuration diagram illustrating another example of the control system applying the semiconductor device according to an embodiment of the disclosure.
Fig. 12 is a circuit diagram illustrating another example of the control system applying the semiconductor device according to an embodiment of the disclosure.
FIG. 13 schematically illustrates a preferred example of a Schottky barrier diode according to the embodiments of the present disclosure.

### [Description of Embodiments]

A power conversion circuit according to the present disclosure is characterized by including at least a switching element that opens and closes an inputted voltage from an input power supply via a reactor and a commutating diode that passes a current in the direction of an electromotive force by a voltage including at least the electromotive force generated from the reactor by energization in an on period of the switching element when the switching element is turned off, the commutating diode including a gallium oxide-based Schottky barrier diode. In an embodiment of the present disclosure, the commutating diode is preferably disposed between the reactor and an output side. In the embodiment of the present disclosure, it is preferable that the power conversion circuit further includes a capacitor and is configured to supply a current passed in the direction of an electromotive force by a voltage including at least the electromotive force generated from the reactor, to the capacitor via the commutating diode. The power conversion circuit is not particularly limited unless it interferes with the present disclosure. In the embodiment of the present disclosure, the power conversion circuit is preferably a conversion circuit and more preferably a step-up conversion circuit.

The switching element is not particularly limited unless it interferes with the present disclosure. The switching element may be a MOSFET or an IGBT. Examples of the switching element include a gallium oxide-based MOSFET, a gallium oxide-based IGBT, a gallium nitride-based HEMT, a SiC-based MOSFET or SiC-based IGBT, and a Si-based MOSFET or Si-based IGBT. In the embodiment of the present disclosure, the switching element is preferably a gallium oxide-based MOSFET, a gallium oxide-based IGBT, a gallium nitride-based HEMT, a SiC-based MOSFET, or a SiC-based IGBT. In the embodiment of the present disclosure, the switching element preferably includes a freewheel diode. The freewheel diode may be integrated in the switching element or disposed outside the switching element.

The commutating diode is not particularly limited if a current is passed in the direction of an electromotive force by a voltage including at least the electromotive force generated from the reactor by energization in an on period of the switching element. In the embodiment of the present disclosure, it is preferable that the power conversion circuit further includes an output capacitor (smoothing capacitor) and is configured to supply the current to the output capacitor. In the embodiment of the present disclosure, the commutating diode is preferably disposed so as to prevent charge accumulated in the output capacitor from flowing backward. This is because a more proper measure is implementable against noise. If a gallium-oxide-based semiconductor is used, the gallium oxide-based Schottky barrier diode is not particularly limited unless it interferes with the present disclosure. Examples of the gallium-oxide-based semiconductor include semiconductors containing gallium oxide or a mixed crystal of gallium oxide. Furthermore, in the embodiment of the present disclosure, the gallium oxide-based Schottky barrier diode is preferably a junction-barrier Schottky diode (JBS). The crystal structure of the gallium-oxide semiconductor is also not particularly limited unless it interferes with the present disclosure. Examples of the crystal structure of the gallium-oxide semiconductor include a corundum structure, a β-gallia structure, a hexagonal structure (e.g., a ε-type structure), an orthorhombic structure (e.g., a κ-type structure), a cubic structure, and a tetragonal structure. In the embodiment of the present disclosure, the crystal structure of the gallium oxide semiconductor is preferably a corundum structure because the power conversion circuit is obtainable with better switching characteristics.

In the embodiment of the present disclosure, the gallium oxide-based Schottky barrier diode preferably includes at least an n- type semiconductor layer having a carrier concentration of 2.0 × 10¹⁷/cm³ or less because the effect of reducing radiated noise is more properly obtainable while reducing generated heat over the circuit. The carrier concentration of the n- type semiconductor layer is preferably within the range of 1.0 × 10¹⁶/cm³ to 5.0 × 10¹⁶/cm³. The thickness of the n- type semiconductor layer is not particularly limited but is preferably 1 µm to 30 µm, more preferably 1 µm to 10 µm, and most preferably 2 µm to 5 µm. The carrier concentration and the thickness of the n- type semiconductor layer are set in the above preferable ranges, thereby improving the switching characteristics while securing heat dissipation. In the embodiment of the present disclosure, the gallium oxide-based Schottky barrier diode preferably further includes an n+ type semiconductor layer. The carrier concentration of the n+ type semiconductor layer is not particularly limited but is typically within the range of 1 × 10¹⁸/cm³ to 1 × 10²¹/cm³. Furthermore, the thickness of the n+ type semiconductor layer is not particularly limited but is preferably 0.1 µm to 30 µm, more preferably 0.1 µm to 10 µm, and most preferably 0.1 µm to 4 µm in the embodiment of the present disclosure. The n+ type semiconductor layer having the preferrable thickness obtains a lower thermal resistance while keeping the switching characteristics.

In the embodiment of the present disclosure, different semiconductors are preferably used for the switching element and the commutating diode. It is more preferable that the semiconductor used for the gallium oxide-based Schottky barrier diode has a larger band gap than a band gap of the semiconductor used for the switching element. Such a preferable configuration allows the switching element to deliver more proper performance even if a semiconductor having a smaller band gap than a band gap of the gallium oxide-based Schottky barrier diode is used for the switching element.

The switching frequency of the power conversion circuit is not particularly limited but is preferably 100 kHz or higher, more preferably 300 kHz or higher, and most preferably 500 kHz or higher in the embodiment of the present disclosure. The Schottky barrier diode of gallium oxide is used as the commutating diode, thereby achieving the power conversion circuit with reduced radiated noise even the switching frequency is at such a high switching frequency.

A power conversion circuit and a power conversion system according to embodiments of the present disclosure will be more specifically described below with reference to the accompanying drawings. The present disclosure is not limited thereto.

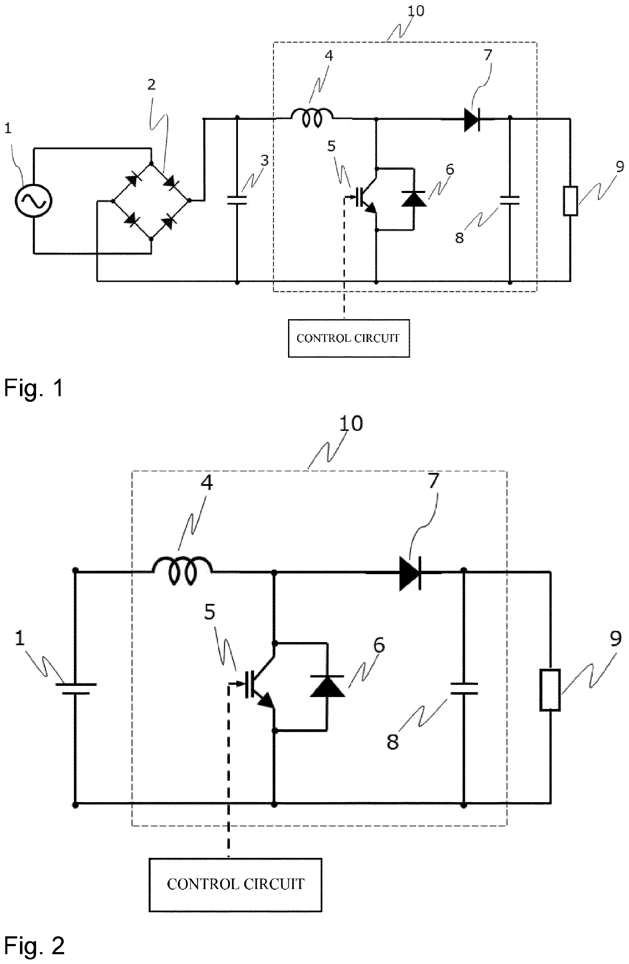

FIG. 1 schematically illustrates a power conversion system including a power conversion circuit according to a first embodiment of the present disclosure. The power conversion system in FIG. 1 is a power-factor improving system including an AC power supply 1, a diode bridge 2, an input capacitor 3, a reactor 4, a switching element 5, a freewheel diode 6, a commutating diode 7, an output capacitor 8, and a load 9. The reactor 4, the switching element, the freewheel diode 6, the commutating diode 7, and the output capacitor 8 constitute a power conversion circuit 10 as a power-factor improving circuit. The diode bridge 2 and the input capacitor 3 constitute a full-wave rectifying circuit and rectify a voltage inputted from the AC power supply 1. The reactor 4 is energized during an on period of the switching element 5, the current of the reactor 4 is commutated to the commutating diode 7 during an off period of the switching element 5, and the output capacitor 8 is charged by the sum of the generated voltage and the input voltage of the reactor 4. These operations are periodically repeated to generate a higher voltage than the input voltage. The on/off operations of the switching element 5 are controlled by using a control circuit, so that an alternating voltage waveform and an alternating current waveform are substantially in phase with each other, the power factor is improved, and the improved voltage is supplied to the load 9. It is also preferable to input values measured using various sensors, which are not illustrated, into the control circuit and perform switching control based on the input signals. The power supply 1 is not particularly limited if the power supply 1 is capable of supplying an alternating voltage. The power supply 1 is, for example, a commercial power supply. For example, the power supply 1 may input a direct voltage or an alternating voltage converted from an alternating voltage by using a desired conversion circuit. the power conversion circuit 10 in FIG. 1 may further include a filter or a transformer.

The commutating diode 7 passes a current in the direction of an electromotive force by a voltage including at least the electromotive force generated from the reactor 4 by energization in an on period of the switching element 5 when the switching element 5 is turned off, and the commutating diode 7 prevents the charge of the output capacitor 8 from flowing backward. In the embodiment of the present disclosure, a gallium oxide-based Schottky barrier diode is used as the commutating diode 7, thereby reducing radiated noise over the power conversion circuit. The reduction of noise leads to a reduction of heat generation over the power conversion circuit. Moreover, the reduction of radiated noise over the power conversion circuit enables downsizing of, for example, noise-control components such as a filter and a capacitor, which are not illustrated.

FIG. 2 schematically illustrates a power conversion system including a power conversion circuit according to a second embodiment of the present disclosure. The power conversion system in FIG. 2 includes a power supply (DC power supply) 1, a reactor 4, a switching element 5, a freewheel diode 6, a commutating diode 7, and an output capacitor 8. The reactor 4, the switching element 5, the freewheel diode 6, the commutating diode 7, and the output capacitor 8 constitute a power conversion circuit 10. The reactor 4 is energized during an on period of the switching element 5, the current of the reactor 4 is commutated to the commutating diode 7 during an off period of the switching element 5, and the output capacitor 8 is charged by the sum of the generated voltage and the input voltage of the reactor 4. These operations are periodically repeated to generate a higher voltage than the input voltage, and the voltage is supplied to a load 9. It is also preferable to input values measured using various sensors, which are not illustrated, into a control circuit and perform switching control based on the input signals. The power supply 1 is not particularly limited if the power supply 1 is capable of supplying a direct voltage. The power supply 1 is, for example, a decentralized power supply, a storage battery, or a generator. For example, the power supply 1 may input a direct voltage or a direct voltage converted from an alternating voltage by using a desired conversion circuit. The power conversion circuit 10 in FIG. 2 may further include a transformer.

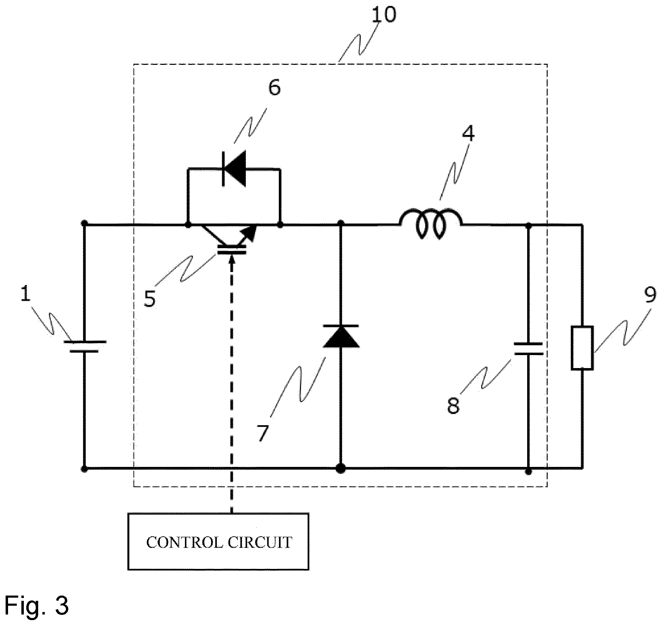

FIG. 3 schematically illustrates a power conversion system including a power conversion circuit according to a third embodiment of the present disclosure. The power conversion system in FIG. 3 includes a power supply (DC power supply) 1, a reactor 4, a switching element 5, a freewheel diode 6, a commutating diode 7, and an output capacitor 8. The reactor 4, the switching element 5, the freewheel diode 6, the commutating diode 7, and the output capacitor 8 constitute a power conversion circuit 10. The reactor 4 is energized during an on period of the switching element 5, the current of the reactor 4 is commutated to the commutating diode 7 during an off period of the switching element 5, and the output capacitor 8 is charged by the generated voltage of the reactor 4. These operations are periodically repeated to generate a lower voltage than the input voltage, and the voltage is supplied to a load 9. It is also preferable to input values measured using various sensors, which are not illustrated, into a control circuit and perform switching control based on the input signals. The power supply 1 is not particularly limited if the power supply 1 is capable of supplying a direct voltage. The power supply 1 is, for example, a decentralized power supply, a storage battery, or a generator. For example, the power supply 1 may input a direct voltage or a direct voltage converted from an alternating voltage by using a desired conversion circuit. The power conversion circuit 10 in FIG. 3 may further include a transformer.

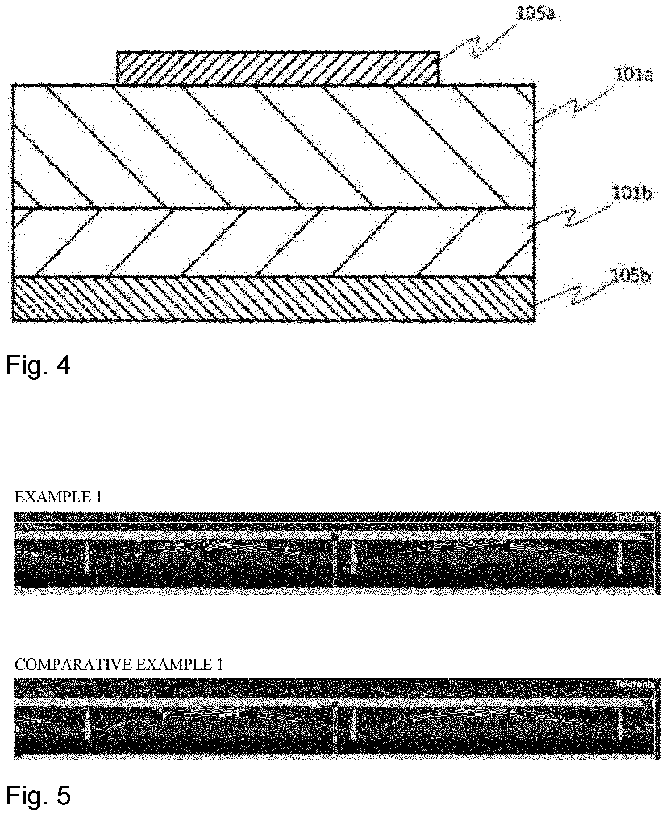

FIG. 4 illustrates an example of the gallium oxide-based Schottky barrier diode (SBD) according to the embodiments of the present disclosure. The SBD in FIG. 4 includes an n- type semiconductor layer 101a, an n+ type semiconductor layer 101b, a Schottky electrode 105a, and an ohmic electrode 105b. In the embodiments of the present disclosure, the n- type semiconductor layer 101a preferably has a carrier concentration of 2.0 × 10¹⁷/cm³ or less because the effect of reducing radiated noise is more properly obtainable while reducing generated heat over the circuit. The carrier concentration of the n+ type semiconductor layer is not particularly limited but is typically within the range of 1 × 10¹⁸/cm³ to 1 × 10²¹/cm³. Furthermore, the thickness of the n+ type semiconductor layer is not particularly limited but is preferably 0.1 µm to 50 µm, more preferably 0.1 µm to 10 µm, and most preferably 0.1 µm to 4 µm in the embodiment of the present disclosure. The n+ type semiconductor layer having the preferrable thickness obtains a lower thermal resistance while keeping the switching characteristics.

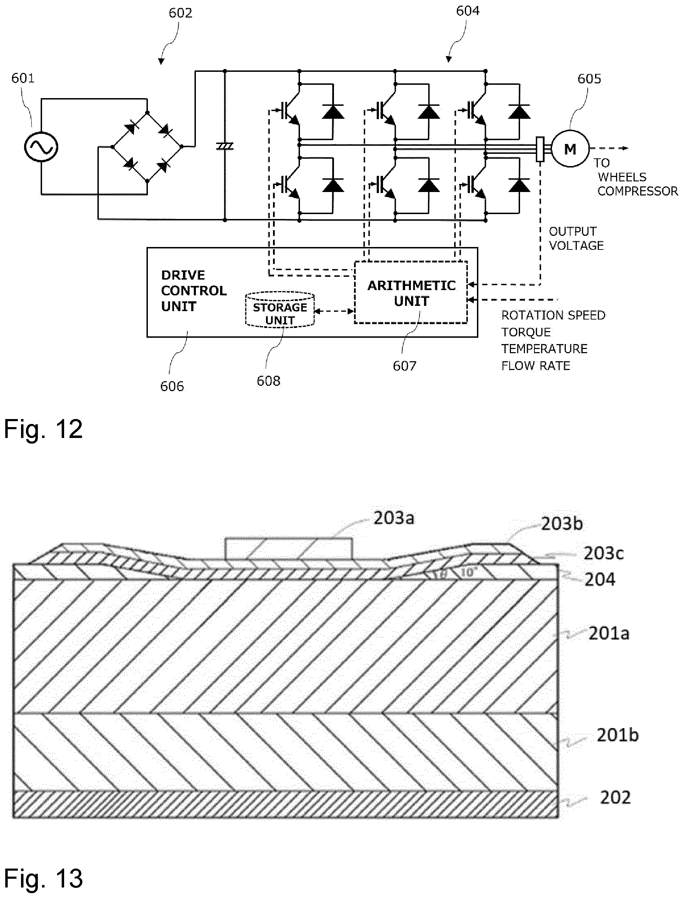

FIG. 13 illustrates a principal part of the Schottky barrier diode (SBD) as one of the preferred embodiments of the present disclosure. The SBD in FIG. 13 includes an ohmic electrode 202, an n- type semiconductor layer 201a, an n+ type semiconductor layer 201b, Schottky electrodes 203a and 203b, and an insulator film (field insulating film) 204. In this configuration, the insulator film 204 has a cone angle of 10° so as to decrease in thickness toward the inside of a semiconductor device. In FIG. 13, the cone angle of the insulator film 204 is 10° but is not limited thereto. The cone angle may be larger than 10° or smaller than 10°. In the embodiments of the present disclosure, the insulator film 204 preferably has a cone angle of 20° or less. The insulator film 204 is formed on the n- type semiconductor layer 101a and has an opening. In the semiconductor device in FIG. 13, the insulator film 204 is capable of suppressing crystal defects on the end portion, more properly forming a depletion layer, improving field limiting, and more properly suppressing leak current. In the semiconductor device in FIG. 13, the outer end portion of a metallic layer 203b and/or a metallic layer 203c serving as a first electrode layer is placed outside the outer end portion of a metallic layer 203a serving as a second electrode layer, thereby more properly suppressing leak current. Furthermore, the outer end portion of the metallic layer 203b and/or the metallic layer 203c outside the outer end portion of the metallic layer 203a has a tapered region that decreases in thickness toward the outside of the semiconductor device, achieving a configuration with higher pressure tightness. Moreover, in the embodiments of the present disclosure, the n- type semiconductor layer preferably has a guard ring (not illustrated). For example, ion implantation of a p-type dopant (e.g., Mg) on the n- type semiconductor layer allows the provision of the guard ring.

Means of forming the layers in FIG. 13 is not particularly limited and may be any known means unless it interferes with the present disclosure. For example, means of forming films by vacuum deposition, CVD, sputtering, or various coating techniques and then patterning the films by photolithography and means of directly patterning films by a printing technique are available.

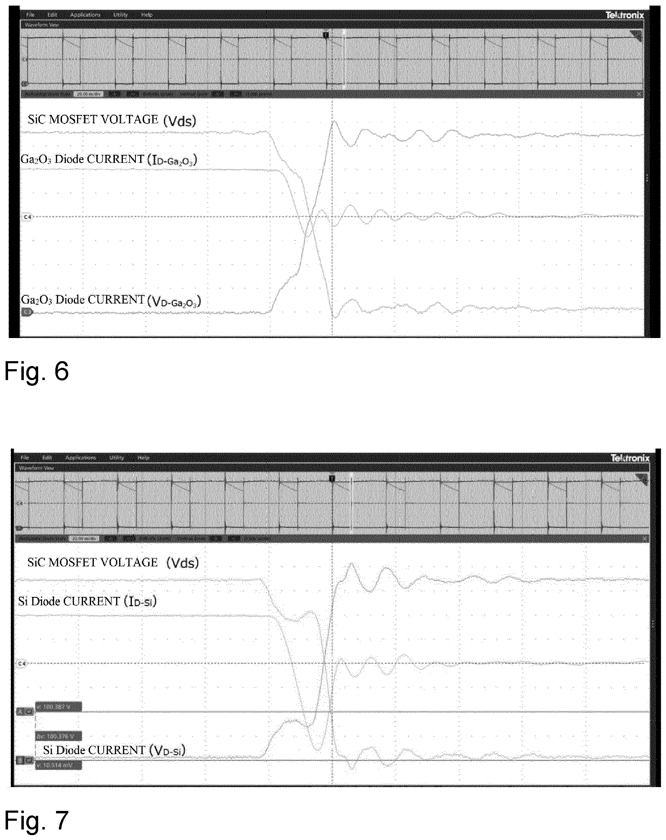

A power-factor improving circuit (PFC circuit) equivalent to the power conversion circuit in FIG. 1 was fabricated and evaluated. A SiC-based MOSFET was used as a switching element. As example 1, a power-factor improving circuit was fabricated with a α-Ga₂O₃-based Schottky barrier diode serving as a commutating diode. As the α-Ga₂O₃-based Schottky barrier diode, an SBD configured as in FIG. 13 was used. As comparative example 1, a power-factor improving circuit was fabricated with a Si-based diode serving as a commutating diode. As comparative example 2, a power-factor improving circuit was fabricated with a SiC-based diode serving as a commutating diode. FIG. 5 shows PFC operation waveforms in example 1 and comparative example 1. As is evident from FIG. 5, in the power conversion circuit of comparative example 1, a recovery current waveform is observed on the PFC operation waveform, whereas in the power conversion circuit of example 1, a recovery current waveform is not observed on the PFC operation waveform, noise in the PFC circuit is reduced, and high controllability is obtained. FIGS. 6, 7, and 8 show the diode turn-off waveforms of example 1, comparative example 1, and comparative example 2, respectively. As is evident from FIGS. 6, 7, and 8, in the power conversion circuit of example 1, the total energy of radiated noise is considerably reduced as compared with the power conversion circuits of comparative example 1 and comparative example 2. Specifically, it is understood that a power changing circuit in which a Schottky barrier diode of gallium oxide is used as a commutating diode is more advantageous in noise characteristics than a power conversion circuit in which a Si-based diode or a SiC-based diode is used as a commutating diode. It was confirmed that noise is reduced in a high-frequency operation at a switching frequency of about 120 kHz in example 1. Moreover, in the power conversion circuit of example 1, heat generation is suppressed also by reducing the total energy of radiated noise. Thus, even if a gallium-oxide-based semiconductor having low thermal conductivity is used, a proper operation is enabled in the power-factor improving circuit. Furthermore, as is evident from FIGS. 6 to 8, the power conversion of example 1 is also capable of reducing the switching loss of the SiC-based MOSFET serving as a switching element. It was also confirmed that the gallium oxide-based Schottky barrier diode obtains excellent switching characteristics particularly when the n- type semiconductor layer has a concentration within the range of 2.0 × 10¹⁷/cm³ or less and a thickness within the range of 1 µm to 10 µm. Moreover, it was confirmed that better switching characteristics are obtained when a Schottky interface has an electrode area within the range of 0.8 mm² to 1.0 mm² and the n- type semiconductor layer has a concentration within the range of 1.0 × 10¹⁶/cm³ to 5.0 × 10¹⁶/cm³ and a thickness within the range of 2 µm to 5 µm.

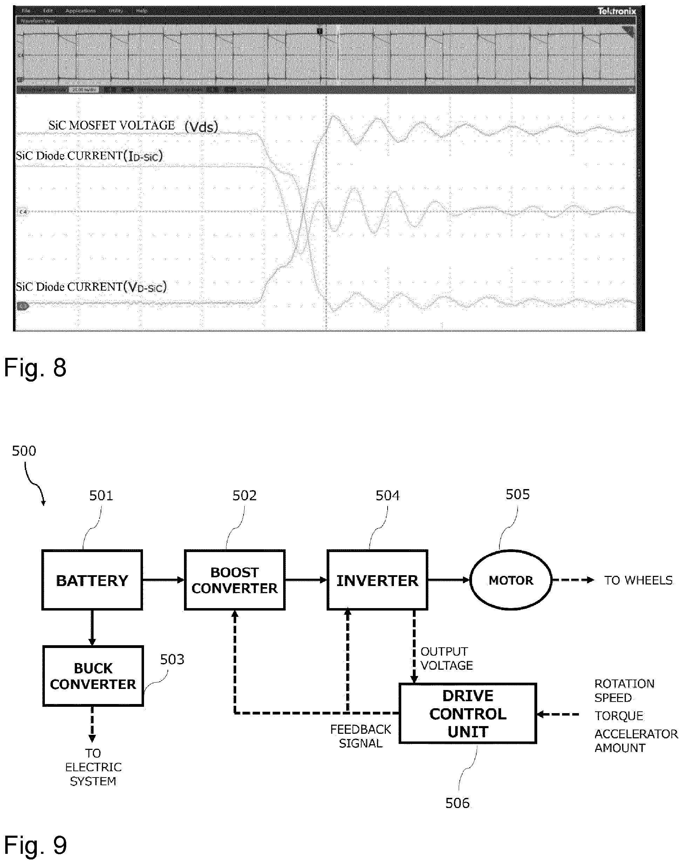

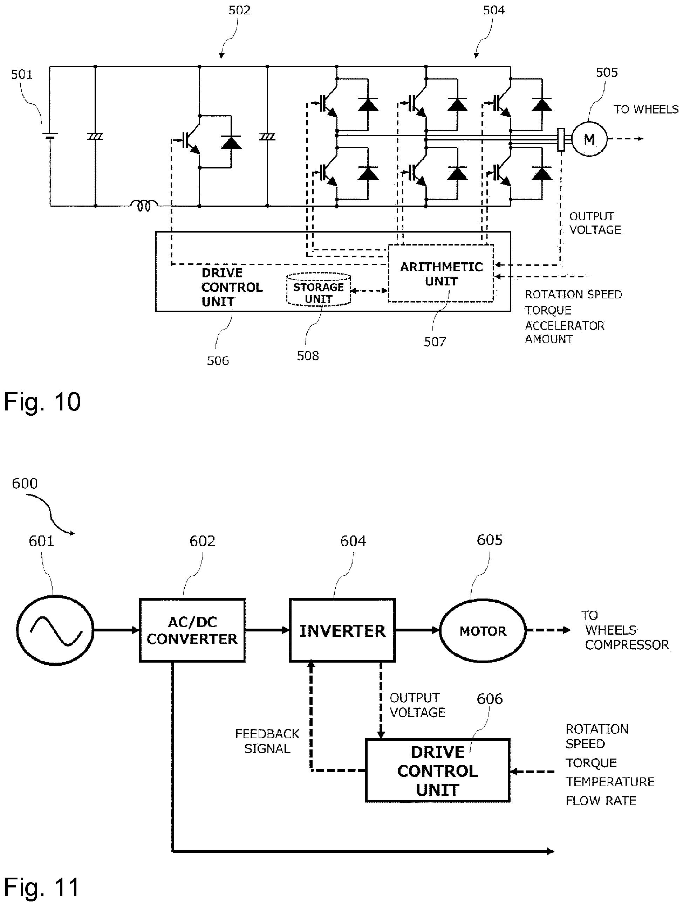

In order to exhibit the functions described above, the power conversion circuit of the disclosure described above can be applied to a power converter such as an inverter or a converter. Fig. 9 is a block diagram illustrating an exemplary control system applying a semiconductor device according to an embodiment of the disclosure, and Fig. 10 is a circuit diagram of the control system particularly suitable for applying to a control system of an electric vehicle.

As shown in Fig. 9, the control system 500 includes a battery (power supply) 501, a boost converter 502, a buck converter 503, an inverter 504, a motor (driving object) 505, a drive control unit 506, which are mounted on an electric vehicle. The battery 501 consists of, for example, a storage battery such as a nickel hydrogen battery or a lithium-ion battery. The battery 501 can store electric power by charging at the power supply station or regenerating at the time of deceleration, and to output a direct current (DC) voltage required for the operation of the driving system and the electrical system of the electric vehicle. The boost converter 502 is, for example, a voltage converter in which a chopper circuit is mounted, and can step-up DC voltage of, for example, 200V supplied from the battery 501 to, for example, 650V by switching operations of the chopper circuit. The step-up voltage can be supplied to a traveling system such as a motor. The buck converter 503 is also a voltage converter in which a chopper circuit is mounted, and can step-down DC voltage of, for example, 200V supplied from the battery 501 to, for example, about 12V. The step-down voltage can be supplied to an electric system including a power window, a power steering, or an electric device mounted on a vehicle.

The inverter 504 converts the DC voltage supplied from the boost converter 502 into three-phase alternating current (AC) voltage by switching operations, and outputs to the motor 505. The motor 505 is a three-phase AC motor constituting the traveling system of an electric vehicle, and is driven by an AC voltage of the three-phase output from the inverter 504. The rotational driving force is transmitted to the wheels of the electric vehicle via a transmission mechanism (not shown).

On the other hand, actual values such as rotation speed and torque of the wheels, the amount of depression of the accelerator pedal (accelerator amount) are measured from an electric vehicle in cruising by using various sensors (not shown), The signals thus measured are input to the drive control unit 506. The output voltage value of the inverter 504 is also input to the drive control unit 506 at the same time. The drive control unit 506 has a function of a controller including an arithmetic unit such as a CPU (Central Processing Unit) and a data storage unit such as a memory, and generates a control signal using the inputted measurement signal and outputs the control signal as a feedback signal to the inverters 504, thereby controlling the switching operation by the switching elements. The AC voltage supplied to the motor 505 from the inverter 504 is thus corrected instantaneously, and the driving control of the electric vehicle can be executed accurately. Safety and comfortable operation of the electric vehicle is thereby realized. In addition, it is also possible to control the output voltage to the inverter 504 by providing a feedback signal from the drive control unit 506 to the boost converter 502.

Fig. 10 is a circuit configuration excluding the buck converter 503 in Fig. 9, in other words, a circuit configuration showing a configuration only for driving the motor 505. As shown in the Fig. 10, the semiconductor device of the disclosure is provided for switching control by, for example, being applied to the boost controller 502 and the inverter 504 as a Schottky barrier diode. The boost converter 502 performs chopper control by incorporating the semiconductor device into the chopper circuit of the boost converter 502. Similarly, the inverter 504 performs switching control by incorporating the semiconductor device into the switching circuit including an IGBT of the inverter 504. The current can be stabilized by interposing an inductor (such as a coil) at the output of the battery 501. Also, the voltage can be stabilized by interposing a capacitor (such as an electrolytic capacitor) between each of the battery 501, the boost converter 502, and the inverter 504.

As indicated by a dotted line in Fig. 10, an arithmetic unit 507 including a CPU (Central Processing Unit) and a storage unit 508 including a nonvolatile memory are provided in the drive control unit 506. Signal input to the drive control unit 506 is given to the arithmetic unit 507, and a feedback signal for each semiconductor element is generated by performing the programmed operation as necessary. The storage unit 508 temporarily holds the calculation result by the calculation unit 507, stores physical constants and functions necessary for driving control in the form of a table, and outputs the physical constants, functions, and the like to the arithmetic unit 507 as appropriate. The arithmetic unit 507 and the storage unit 508 can be provided by a known configuration, and the processing capability and the like thereof can be arbitrarily selected.

As shown in Figs. 9 and 10, a diode and a switching element such as a thyristor, a power transistor, an IGBT, a MOSFET and the like is employed for the switching operation of the boost converter 502, the buck converter 503 and the inverter 504 in the control system 500. The use of gallium oxide (Ga 2 O3) specifically corundum-type gallium oxide (*α* -Ga 2 O3) as its materials for these semiconductor devices greatly improves switching properties. Further, extremely outstanding switching performance can be expected and miniaturization and cost reduction of the control system 500 can be realized by applying a semiconductor film or a semiconductor device of the disclosure. That is, each of the boost converter 502, the buck converter 503 and the inverter 504 can be expected to have the benefit of the disclosure, and the effect and the advantages can be expected in any one or combination of the boost converter 502, the buck converter 503 and the inverter 504, or in any one of the boost converter 502, the buck converter 503 and the inverter 504 together with the drive control unit 506. The control system 500 described above is not only applicable to the control system of an electric vehicle of the semiconductor device of the disclosure, but can be applied to a control system for any applications such as to step-up and step-down the power from a DC power source, or convert the power from a DC to an AC. It is also possible to use a power source such as a solar cell as a battery.

Fig. 11 is a block diagram illustrating another exemplary control system applying a semiconductor device according to an embodiment of the disclosure, and Fig. 12 is a circuit diagram of the control system suitable for applying to infrastructure equipment and home appliances or the like operable by the power from the AC power source.

As shown in Fig. 11, the control system 600 is provided for inputting power supplied from an external, such as a three-phase AC power source (power supply) 601, and includes an AC/DC converter 602, an inverter 604, a motor (driving object) 605 and a drive control unit 606 that can be applied to various devices described later. The three-phase AC power supply 601 is, for example, a power plant (such as a thermal, hydraulic, geothermal, or nuclear plant) of an electric power company, whose output is supplied as an AC voltage while being downgraded through substations. Further, the three-phase AC power supply 601 is installed in a building or a neighboring facility in the form of a private power generator or the like for supplying the generated power via a power cable. The AC/DC converter 602 is a voltage converter for converting AC voltage to DC voltage. The AC/DC converter 602 converts AC voltage of 100V or 200V supplied from the three-phase AC power supply 601 to a predetermined DC voltage. Specifically, AC voltage is converted by a transformer to a desired, commonly used voltage such as 3. 3V, 5V, or 12V. When the driving object is a motor, conversion to 12V is performed. It is possible to adopt a single-phase AC power supply in place of the three-phase AC power supply. In this case, same system configuration can be realized if an AC/DC converter of the single-phase input is employed.

The inverter 604 converts the DC voltage supplied from the AC/DC converter 602 into three-phase AC voltage by switching operations and outputs to the motor 605. Configuration of the motor 605 is variable depending on the control object. It can be a wheel if the control object is a train, can be a pump and various power source if the control objects a factory equipment, can be a three-phase AC motor for driving a compressor or the like if the control object is a home appliance. The motor 605 is driven to rotate by the three-phase AC voltage output from the inverter 604, and transmits the rotational driving force to the driving object (not shown).

There are many kinds of driving objects such as personal computer, LED lighting equipment, video equipment, audio equipment and the like capable of directly supplying a DC voltage output from the AC/DC inverter 602. In that case the inverter 604 becomes unnecessary in the control system 600, and a DC voltage from the AC/DC inverter 602 is supplied to the driving object directly as shown in Fig. 11. Here, DC voltage of 3. 3V is supplied to personal computers and DC voltage of 5V is supplied to the LED lighting device for example.

On the other hand, rotation speed and torque of the driving object, measured values such as the temperature and flow rate of the peripheral environment of the driving object, for example, is measured using various sensors (not shown), these measured signals are input to the drive control unit 606. At the same time, the output voltage value of the inverter 604 is also input to the drive control unit 606. Based on these measured signals, the drive control unit 606 provides a feedback signal to the inverter 604 thereby controls switching operations by the switching element of the inverter 604. The AC voltage supplied to the motor 605 from the inverter 604 is thus corrected instantaneously, and the operation control of the driving object can be executed accurately. Stable operation of the driving object is thereby realized. In addition, when the driving object can be driven by a DC voltage, as described above, feedback control of the AC/DC controller 602 is possible in place of feedback control of the inverter.

Fig. 12 shows the circuit configuration of Fig. 11. As shown in Fig. 12, the semiconductor device of the disclosure is provided for switching control by, for example, being applied to the AC/DC converter 602 and the inverter 604 as a Schottky barrier diode. The AC/DC converter 602 has, for example, a circuit configuration in which Schottky barrier diodes are arranged in a bridge-shaped, to perform a direct-current conversion by converting and rectifying the negative component of the input voltage to a positive voltage. Schottky barrier diodes can also be applied to a switching circuit in IGBT of the inverter 604 to perform switching control. The voltage can be stabilized by interposing a capacitor (such as an electrolytic capacitor) between the AC/DC converter 602 and the inverter 604.

As indicated by a dotted line in Fig. 12, an arithmetic unit 607 including a CPU and a storage unit 608 including a nonvolatile memory are provided in the drive control unit 606. Signal input to the drive control unit 606 is given to the arithmetic unit 607, and a feedback signal for each semiconductor element is generated by performing the programmed operation as necessary. The storage unit 608 temporarily holds the calculation result by the arithmetic unit 607, stores physical constants and functions necessary for driving control in the form of a table, and outputs the physical constants, functions, and the like to the arithmetic unit 607 as appropriate. The arithmetic unit 607 and the storage unit 608 can be provided by a known configuration, and the processing capability and the like thereof can be arbitrarily selected.

In such a control system 600, similarly to the control system 500 shown in Figs. 9 and 10, a diode or a switching element such as a thyristor, a power transistor, an IGBT, a MOSFET or the like is also applied for the purpose of the rectification operation and switching operation of the AC/DC converter 602 and the inverter 604. Switching performance can be improved by the use of gallium oxide (Ga₂O₃), particularly corundum-type gallium oxide (α-Ga₂O₃), as materials for these semiconductor elements. Further, extremely outstanding switching performance can be expected and miniaturization and cost reduction of the control system 600 can be realized by applying a semiconductor film or a semiconductor device of the disclosure. That is, each of the AC/DC converter 602 and the inverter 604 can be expected to have the benefit of the disclosure, and the effects and the advantages of the disclosure can be expected in any one or combination of the AC/DC converter 602 and the inverter 604, or in any of the AC/DC converter 602 and the inverter 604 together with the drive control unit 606.

Although the motor 605 has been exemplified in Figs. 11 and 12, the driving object is not necessarily limited to those that operate mechanically. Many devices that require an AC voltage can be a driving object. It is possible to apply the control system 600 as long as electric power is obtained from AC power source to drive the driving object. The control system 600 can be applied to the driving control of any electric equipment such as infrastructure equipment (electric power facilities such as buildings and factories, telecommunication facilities, traffic control facilities, water and sewage treatment facilities, system equipment, labor-saving equipment, trains and the like) and home appliances (refrigerators, washing machines, personal computers, LED lighting equipment, video equipment, audio equipment and the like).

The embodiments according to the present disclosure are allowed to be combined, some of the constituent elements are surely applicable to other embodiments, some of the constituent elements are allowed to be increased or reduced in number and combined with other known techniques. The configuration is changeable by, for example, a partial omission unless it interferes with the present disclosure. Such a change of the configuration also belongs to the embodiments of the present disclosure.

### [Reference Signs List]

1 Power supply
2 Diode bridge
3 Input capacitor
4 Reactor
5 Switching element
6 Freewheel diode
7 Commutating diode
8 Output capacitor (smoothing capacitor)
9 Load
10 Power conversion circuit
101a N- type semiconductor layer
101b N+ type semiconductor layer
102 P-type semiconductor layer
103 Semi-insulating layer
104 Insulating layer
105a Schottky electrode
105b Ohmic electrode
201a N- type semiconductor layer
201b N+ type semiconductor layer
202 Ohmic electrode
203 Schottky electrode
203a Metallic layer
203b Metallic layer
203c Metallic layer
204 Insulator film
500 control system
501 battery (power supply)
502 boost converter
503 buck converter
504 inverter
505 motor (driving object)
506 drive control unit
507 arithmetic unit
508 storage unit
600 control system
601 three-phase AC power supply
602 AC/DC converter
604 inverter
605 motor (driving object)
606 drive control unit
607 arithmetic unit
608 storage unit

## Claims

1. A power conversion circuit comprising at least:
a switching element that opens and closes an inputted voltage via a reactor; and
a commutating diode that passes a current in a direction of an electromotive force by a voltage including at least the electromotive force generated from the reactor when the switching element is turned off, the commutating diode including a gallium oxide-based Schottky barrier diode.

2. The power conversion circuit according to claim 1, wherein the reactor is disposed on an input side than the commutating diode.

3. The power conversion circuit according to claim 1 or 2, further comprising an output capacitor, the power conversion circuit being configured to supply the current to the output capacitor.

4. The power conversion circuit according to any one of claims 1 to 3, wherein the switching element includes a freewheel diode.

5. The power conversion circuit according to any one of claims 1 to 4, wherein the switching element includes a gallium oxide-based MOSFET, a gallium oxide-based IGBT, a gallium nitride-based HEMT, a SiC-based MOSFET, or a SiC-based IGBT.

6. The power conversion circuit according to any one of claims 1 to 5, wherein different semiconductors are used for the switching element and the commutating diode.

7. The power conversion circuit according to any one of claims 1 to 6, wherein the semiconductor used for the gallium oxide-based Schottky barrier diode has a larger band gap than a band gap of the semiconductor used for the switching element.

8. The power conversion circuit according to any one of claims 1 to 7, wherein the gallium oxide-based Schottky barrier diode includes at least an n- type semiconductor layer having a carrier concentration of 2.0 × 10¹⁷/cm³ or less.

9. The power conversion circuit according to claim 8, wherein the n- type semiconductor layer has a thickness of 1 µm to 10 µm.

10. The power conversion circuit according to any one of claims 1 to 9, wherein the power conversion circuit is a step-up conversion circuit.

11. A power conversion system comprising at least:
a switching element that opens and closes an input voltage via a reactor, the input voltage being supplied from a power supply;
a control circuit that controls on and off of the switching element;
a commutating diode that passes a current in a direction of an electromotive force by a voltage including at least the electromotive force generated from the reactor when the switching element is turned off; and
an output capacitor,
wherein a gallium oxide-based Schottky barrier diode is used as the commutating diode.

12. The power conversion system according to claim 11, wherein the reactor is disposed on an input side than the commutating diode.

13. The power conversion system according to claim 11 or 12, wherein the switching element includes a freewheel diode.

14. The power conversion system according to any one of claims 11 to 13, wherein the switching element includes a gallium oxide-based MOSFET, a gallium oxide-based IGBT, a gallium nitride-based HEMT, a SiC-based MOSFET, or a SiC-based IGBT.

15. The power conversion system according to any one of claims 11 to 14, wherein the gallium oxide-based Schottky barrier diode includes at least an n- type semiconductor layer having a carrier concentration of 2.0 × 10¹⁷/cm³ or less.
